# FASCICULE DE BREVET EUROPEEN

(11) **EP 3 422 805 B1**
(45) Date de publication et mention de la délivrance du brevet: **02.10.2019**
(21) Numéro de dépôt: 18172703.3
(22) Date de dépôt: 16.05.2018
(51) Int. Cl.: H05B 3/26, B64C 27/32, B64C 39/02, B64D 15/12, H05K 3/00, H05K 3/18

(54) **PROCEDE DE FABRICATION D'UN EQUIPEMENT TOURNANT DE VOILURE TOURNANTE MUNI D'UN DEGIVREUR, LEDIT EQUIPEMENT TOURNANT, ET UN DRONE MUNI DUDIT EQUIPEMENT TOURNANT**
HERSTELLUNGSVERFAHREN EINER DREHBAREN AUSRÜSTUNG MIT DREHFLÜGELN, DIE MIT EINEM ENTEISER AUSGESTATTET IST, DIESE DREHBARE AUSRÜSTUNG UND EINE DROHNE, DIE MIT DIESER DREHBAREN AUSRÜSTUNG AUSGESTATTET IST
METHOD FOR PRODUCING A ROTARY-WING ROTARY SYSTEM PROVIDED WITH A DE-ICER, SAID ROTARY SYSTEM, AND DRONE PROVIDED WITH SAID ROTARY SYSTEM

(30) Priorité: 27.06.2017 FR 1770681
(43) Date de publication de la demande: 02.01.2019
(73) Titulaire: Airbus Helicopters, 13725 Marignane Cedex (FR)
(72) Inventeur: GIBERT, Gauthier, 13580 LA FARE LES OLIVIERS (FR); IMBERT, Nicolas, 13008 MARSEILLE (FR)
(74) Mandataire: GPI & Associés

(56) Documents cités:
- EP-A1- 2 762 407
- FR-A1- 3 028 242
- GB-A- 2 291 575
- US-A1- 2016 363 367

## Description

La présente invention concerne un procédé de fabrication d'un équipement tournant de voilure tournante muni d'un dégivreur, ledit équipement tournant, et un drone muni dudit équipement tournant.

L'invention se situe donc dans le domaine technique restreint des drones, et des systèmes de dégivrage des drones.

Un hélicoptère est parfois muni d'un système de dégivrage. Ce système de dégivrage peut comprendre des tapis chauffants agencés dans les pales du rotor principal de l'hélicoptère. Chaque tapis chauffant est disposé entre une coiffe de bord d'attaque d'une pale et un corps de la pale. Les tapis chauffants sont alimentés électriquement par une source d'énergie électrique agencée dans l'hélicoptère. Dès lors, un collecteur électrique est agencé dans un mât rotor qui entraîne en rotation le rotor principal, ce collecteur électrique comprenant une partie fixe reliée électriquement à la source d'énergie électrique et une partie mobile reliée électriquement aux tapis chauffants.

Cette technologie est éprouvée mais ne paraît pas transposable à un drone muni de rotors, et notamment un drone de petite taille.

Un drone présente de fait des dimensions réduites. Dès lors, les rotors du drone comprennent des pales ayant aussi des dimensions réduites. Par conséquent, l'agencement d'un tapis chauffant dans une pale d'un rotor de drone paraît difficile. En outre, les connecteurs électriques aptes à relier deux fils électriques présentent usuellement des dimensions qui paraissent trop importantes au regard des dimensions des pales d'un rotor d'un drone.

L'agencement d'un dégivreur sur une pale de drone est donc difficile à envisager.

De plus, un rotor de drone est mis en rotation par un mât rotor plein, ce qui paraît incompatible avec l'agencement d'un collecteur électrique d'hélicoptère.

Selon un autre aspect, un procédé de fabrication est connu sous l'acronyme « LDS » et l'expression anglaise correspondante « Laser Direct Structuring », ou encore sous l'expression française « structuration directe au laser ». Ce procédé est utilisé pour générer une piste électriquement conductrice sur un support. Ce support présente un matériau composite ou thermoplastique comprenant un additif, cet additif prenant la forme d'un métal organique. Cet additif est « activé » par le passage d'un laser. Ce laser crée des cratères et des rainures microscopiques dans lesquels du cuivre peut être ancré fermement en plongeant la pièce dans un bain catalyseur.

Ce procédé n'est pas lié au dégivrage de pale, mais permet d'obtenir des pièces non résistives électriquement pour éviter une perte de signal. Ces pièces ne paraissent donc pas adaptées pour subir un échauffement par effet joule.

Les documents CN101859613, US 2015/175805 et US 2015/280312 ont trait à ce procédé LDS.

Les documents US 9462699, EP2591638, GB 2291575, EP2762407 et FR 3028242 sont par ailleurs connus.

Le document US 2016/363367 est très éloigné du domaine de l'invention en ayant trait à un réfrigérateur.

La présente invention a alors pour objet de proposer un procédé permettant d'obtenir un équipement tournant pour drone muni d'un dégivreur.

L'invention vise notamment un procédé de fabrication d'un équipement tournant pour drone. L'équipement tournant participe au moins partiellement à la propulsion et/ou à la sustentation d'un drone. L'équipement tournant comprend un ensemble tournant équipé d'un dégivreur, cet ensemble tournant comprenant au moins une pale. Le procédé comporte la fabrication dudit d'un équipement tournant par un procédé de structuration directe au laser en réalisant les étapes de :
- fabrication de l'ensemble tournant, cet ensemble tournant comprenant une enveloppe, cette enveloppe comprenant un matériau composite muni d'un métal organique,
- réalisation avec un laser d'au moins un sillon sur une face extérieure de l'enveloppe, ce sillon s'étendant d'une première extrémité vers une deuxième extrémité, ce sillon étant au moins ménagé sur ladite au moins une pale, ce sillon présentant au moins un changement de direction sur ladite au moins une pale,
- réalisation d'une piste électriquement conductrice du dégivreur dans ledit au moins un sillon en plongeant l'ensemble tournant dans un bain contenant un métal, par exemple du cuivre, ladite piste électriquement conductrice s'étendant d'une première borne jusqu'à une deuxième borne, la première borne étant présente dans la première extrémité, la deuxième borne étant présente dans la deuxième extrémité,
- recouvrement de la piste électriquement conductrice avec une couche de protection.

L'expression « changement de direction » signifie que la piste électriquement conductrice n'est pas rectiligne. La piste électriquement conductrice peut ainsi présenter un tronçon entrant dans une pale et un tronçon sortant de cette pale selon un sens de circulation d'un courant électrique le long de la piste électriquement conductrice.

Dès lors, le procédé permet de fabriquer un ensemble tournant par des méthodes usuelles, par exemple par impression 3D, par moulage, par injection...

Cet ensemble tournant comporte en outre une enveloppe incluant un métal organique pour pourvoir être structuré par un procédé de structuration directe par laser. Des matériaux connus compatibles avec ce procédé sont envisageables. Par exemple, l'enveloppe comporte un matériau composite chargé de cuivre.

Durant cette structuration directe par laser, un laser creuse dans l'ensemble tournant au moins une gorge suivant un patron prédéfini. Chaque gorge est dénommée « sillon » par commodité. Le laser pouvant être agencé sur un bras robotisé, ce laser peut dessiner des sillons ayant des formes complexes, par exemple en escargot, en zigzags ... Chaque sillon accueille en outre une piste électriquement conductrice, par exemple en cuivre, réalisée durant une étape de métallisation.

Eventuellement, chaque pale comporte au moins une piste électriquement conductrice qui serpente au moins au niveau du bord d'attaque d'une pale.

Une partie de cette piste électriquement conductrice représente un organe de dégivrage par résistance ohmique d'un dégivreur, d'autres tronçons représentant des lignes de connexion électrique.

Contrairement aux procédés classiques de structuration directe par laser qui visent à réaliser des pistes électriques peu résistives électriquement, l'invention propose de réaliser une piste électrique présentant une résistivité électrique importante pour chauffer par effet Joule sous la tension électrique appliquée aux bornes.

En effet, la demanderesse note qu'il est possible d'obtenir une piste électriquement conductrice de faibles dimensions traversée par un courant électrique, ce courant électrique présentant une tension électrique particulière aux bornes de cette piste électriquement conductrice pour engendrer un échauffement de la pale dans un but de dégivrage.

Dès lors, ce procédé permet d'obtenir une pale de faibles dimensions munie d'un dégivreur.

De plus, les pistes électriquement conductrices peuvent fonctionner avec une énergie électrique relativement faible et optimiser les sources d'énergies électriques du drone.

En outre, les pistes électriquement conductrices peuvent permettre d'augmenter la robustesse mécanique de la pale.

Par ailleurs, une ou plusieurs voire chaque piste électriquement conductrice est recouverte d'une couche de protection, par exemple de type résine pyralène. Cette couche de protection tend à ralentir l'érosion d'une piste électriquement conductrice.

Le procédé selon l'invention peut de plus comporter une ou plusieurs des caractéristiques suivantes.

Ainsi, l'ensemble tournant peut être réalisé uniquement avec le matériau de l'enveloppe.

Selon une autre option, la fabrication de l'ensemble tournant peut comporter une étape de confection d'un noyau central et une étape de recouvrement dudit noyau central avec ladite enveloppe.

Par exemple, un corps de pale en bois est recouvert de l'enveloppe selon l'invention.

Selon un aspect, ladite piste électriquement conductrice s'étendant sur une longueur entre la première borne et la deuxième borne, ladite piste électriquement conductrice s'étendant selon une épaisseur d'une face inférieure en contact avec un fond dudit au moins un sillon jusqu'à une face supérieure, ladite piste électriquement conductrice s'étendant selon une largeur entre deux côtés respectivement en contact avec deux flancs dudit au moins un sillon, ladite épaisseur et ladite largeur peuvent être comprises chacune entre 30 microns inclus et 60 microns inclus.

Cette dimension permet d'obtenir une piste électriquement conductrice résistive qui chauffe par effet Joule lorsqu'un courant électrique circule dans cette piste électriquement conductrice, et notamment un courant électrique induisant une tension électrique de l'ordre de 10 Volts à 14 Volts aux bornes de la piste électriquement conductrice.

Selon un aspect, l'ensemble tournant pouvant comprendre au moins deux pales et un moyeu, lesdites au moins deux pales étant portées par ledit moyeu, lesdites au moins deux pales et ledit moyeu peuvent former une pièce monolithique.

Les pales et le moyeu forment une seule et même pièce qui peut être réalisée en une opération.

Selon un aspect, la piste électriquement conductrice peut s'étendre sur ledit moyeu et sur au moins une pale, ladite première extrémité et ladite deuxième extrémité ainsi que la première borne et la deuxième borne étant présentes sur ledit moyeu.

Par exemple, une seule piste électriquement conductrice serpente sur toutes les pales et le moyeu.

Outre un procédé, l'invention vise un équipement tournant pour drone, cet équipement tournant ayant un ensemble tournant qui comporte au moins une pale.

Cet ensemble tournant comporte une enveloppe, au moins un sillon s'étendant sur une face extérieure de ladite enveloppe d'une première extrémité vers une deuxième extrémité, ledit au moins un sillon étant au moins ménagé sur ladite pale, ledit au moins un sillon présentant au moins un changement de direction sur ladite pale, ledit ensemble tournant comprenant au moins un dégivreur, ledit dégivreur comprenant une piste électriquement conductrice s'étendant dans ledit au moins un sillon, ladite piste électriquement conductrice s'étendant d'une première borne jusqu'à une deuxième borne, la première borne étant présente dans la première extrémité, la deuxième borne étant présente dans la deuxième extrémité, ledit dégivreur comprenant une couche de protection recouvrant ladite piste électriquement conductrice.

L'équipement tournant peut de plus comprendre une ou plusieurs des caractéristiques qui suivent.

Ainsi, l'ensemble tournant peut comporter un noyau central agencé dans ladite enveloppe.

Selon un aspect, ladite piste électriquement conductrice s'étendant sur une longueur entre la première borne et la deuxième borne, ladite piste électriquement conductrice s'étendant selon une épaisseur d'une face inférieure en contact avec un fond dudit au moins un sillon jusqu'à une face supérieure, ladite piste électriquement conductrice s'étendant selon une largeur entre deux côtés respectivement en contact avec deux flancs dudit au moins un sillon, ladite épaisseur et ladite largeur peuvent être comprises chacune entre 30 microns inclus et 60 microns inclus.

Selon un aspect, ledit ensemble tournant pouvant comprendre au moins deux pales et un moyeu, lesdites au moins deux pales étant portées par ledit moyeu, lesdites au moins deux pales et ledit moyeu peuvent former une pièce monolithique.

Contrairement à un hélicoptère, toutes les pales et le moyeu peuvent former une seule et unique pièce, et donc un seul et unique bloc.

Selon un aspect, une piste électriquement conductrice peut s'étendre sur ledit moyeu et sur au moins une pale, ladite première extrémité et ladite deuxième extrémité ainsi que ladite première borne et ladite deuxième borne étant présentes sur ledit moyeu.

Selon un aspect, ladite couche de protection peut comporter un vernis polyuréthane.

Une telle couche de protection peut aisément être appliquée avec une bombe de projection de vernis.

Outre un équipement tournant pour drone, l'invention vise un drone muni d'un corps, ce corps portant au moins un rotor. Dès lors, ledit au moins un rotor comporte un équipement tournant selon l'invention.

Par exemple, tous les rotors comportent un équipement tournant selon l'invention.

Selon un aspect, ledit drone comportant un moteur électrique muni d'un bâti et d'un mât rotor, ledit mât rotor étant relié mécaniquement audit ensemble tournant, ledit drone peut comporter un collecteur électrique, ledit collecteur électrique ayant une partie fixe reliée électriquement à une partie mobile, ladite partie fixe étant reliée électriquement à une source d'énergie électrique, ladite partie mobile étant reliée électriquement à ladite première borne et à ladite deuxième borne, ladite partie mobile étant solidarisée audit mât rotor et étant agencée autour du mât rotor.

Le drone possède ainsi une ou plusieurs sources d'énergie. Par ailleurs, chaque source d'énergie peut comporter une ou plusieurs batteries, une ou plusieurs piles...

Dès lors, un rotor muni d'un équipement tournant selon l'invention coopère avec un collecteur électrique qui est agencé autour d'un mât rotor. Chaque collecteur électrique permet la circulation d'un courant électrique d'une source d'énergie électrique placée dans un repère fixe vers chaque pale d'un rotor présente dans un repère tournant.

Le cas échéant, une unique source d'énergie peut être reliée à tous les collecteurs électriques du drone.

L'expression « collecteur électrique » désigne un équipement permettant de transférer un courant électrique, et éventuellement de le transformer, entre un repère fixe et un repère tournant.

Par exemple, des collecteurs de type « collecteurs à balais » sont utilisés. Un tel collecteur électrique comporte au moins une piste électrique dénommée « ligne électrique » par commodité et au moins un balai en contact sur cette ligne électrique. Selon une variante, la ligne électrique est portée par la partie mobile et chaque balai est porté par la partie fixe. Selon une autre variante, la ligne électrique est portée par la partie fixe et chaque balai est porté par la partie mobile.

Selon un autre exemple, le collecteur électrique peut comprendre un transformateur rotatif. Par exemple, un transformateur du type décrit dans le document US 5572178 est envisageable.

Par ailleurs, le drone peut comporter un interrupteur ou équivalent pour que chaque piste électriquement conductrice du drone soit alimentée électriquement, ou ne soit pas alimentée électriquement. Cet interrupteur peut être commandé à distance par une commande de dégivrage via une liaison non filaire. Eventuellement, la commande de dégivrage commande soit le dégivrage de toutes les pales, soit interdit ledit dégivrage sur toutes les pales. La commande de dégivrage est alors du type « tout ou rien »

Selon un aspect, la partie mobile peut être fixée à un organe élastique, ledit organe élastique étant fixé au mât rotor.

L'organe élastique peut comprendre une bague collée sur le mât rotor. Par exemple, la bague comporte un élastomère.

L'organe élastique peut tendre à permettre au collecteur électrique de fonctionner en présence d'un léger désaxage du mât rotor.

Selon un aspect, ladite partie fixe peut être fixée audit bâti.

Par exemple, le moteur électrique peut comprendre un bâti et un mât rotor saillant du bâti. Ce mât rotor traverse alors le collecteur électrique pour être fixé à l'ensemble tournant.

La partie fixe du collecteur électrique est alors verrouillée sur le bâti du moteur. Cette partie fixe est ainsi immobile en rotation dans le repère du drone, contrairement à la partie mobile qui effectue une rotation conjointement avec le mât rotor et relativement au bâti.

Selon un aspect, au moins deux fils peuvent s'étendre de ladite partie mobile jusqu'à respectivement ladite première borne et ladite deuxième borne, un desdits au moins deux fils étant accolé à ladite première borne et un desdits au moins deux fils étant accolé à ladite deuxième borne, un manchon thermo-rétractable entourant lesdits au moins deux fils ainsi que ladite première borne et ladite deuxième borne.

Chaque fil peut être brasé et/ou encollé à une borne sous le manchon. Ce manchon procure à la connexion électrique une protection mécanique et environnementale.

Selon un aspect, la source d'énergie peut délivrer un courant électrique sous une tension électrique comprise entre 12 Volts inclus et 14 Volts inclus.

Plusieurs niveaux de tensions électriques sont possibles. De manière préférentielle, la source d'énergie délivre un niveau de tension électrique compris entre 12 Volts et 14 Volts pour optimiser le dégivrage.

L'invention et ses avantages apparaîtront avec plus de détails dans le cadre de la description qui suit avec des exemples donnés à titre illustratif en référence aux figures annexées qui représentent :
- la figure 1, un schéma d'un équipement tournant selon l'invention,
- la figure 2 à 4, des schémas présentant les étapes du procédé selon l'invention,
- la figure 5, un schéma d'un drone selon l'invention, et
- la figure 6, un schéma illustrant un équipement tournant dudit drone.

Les éléments présents dans plusieurs figures distinctes sont affectés d'une seule et même référence.

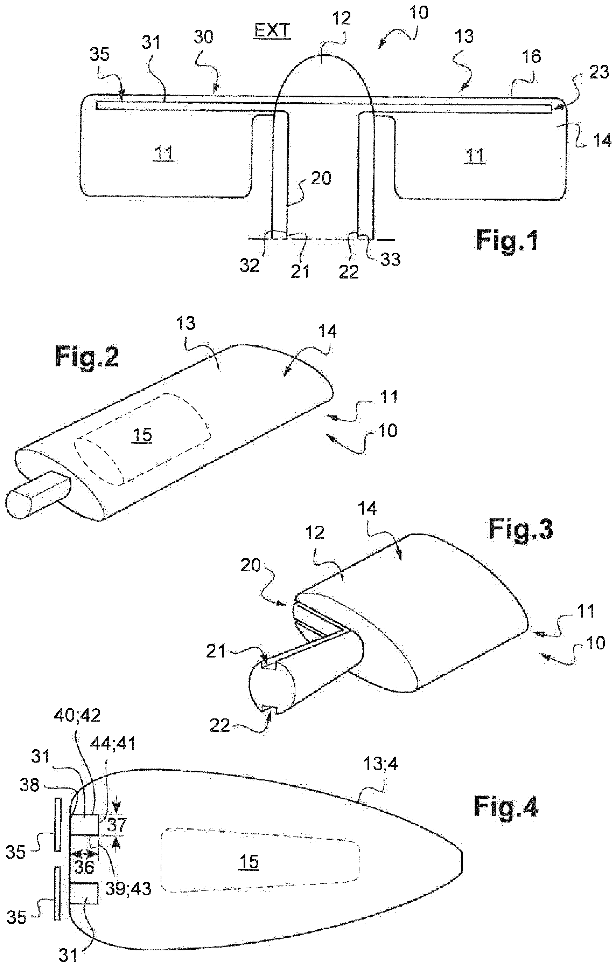

La figure 1 illustre un équipement tournant pour drone selon l'invention.

Cet équipement tournant comporte un ensemble tournant 10 aérodynamique qui est muni d'au moins une pale 11. Par exemple, cet ensemble tournant 10 comporte plusieurs pales 11 qui sont éventuellement rigidement fixées à un moyeu 12. Le moyeu 12 peut alors être fixé à un mât rotor d'un drone.

Le cas échéant, le moyeu 12 et les pales 11 forment une seule et même pièce, contrairement aux rotors munis de pales brochées à un moyeu par exemple.

Par ailleurs, cet ensemble tournant 10 est pourvu d'une enveloppe 13. Selon la variante, l'ensemble tournant 10 peut comprendre un ou plusieurs noyaux centraux recouverts de cette enveloppe 13, ou peut comprendre uniquement l'enveloppe 13 qui peut éventuellement être pleine.

Indépendamment de la présence ou de l'absence d'un noyau central au sein de l'enveloppe 13, l'ensemble tournant 10 comporte au moins un dégivreur 30.

Ainsi, l'ensemble tournant 10 est muni d'au moins un sillon 20 ménagé dans l'enveloppe 13, et notamment dans une face extérieure 14 de l'enveloppe 13 en regard d'un milieu extérieur EXT situé à l'extérieur de l'ensemble tournant 10. Ce sillon 20 est sensiblement délimité par un fond et des flancs formant un U afin que le sillon soit ouvert sur le milieu extérieur EXT.

Ce sillon 20 s'étend d'une première extrémité 21 vers une deuxième extrémité 22. Ce sillon 20 serpente donc sur la face extérieure 14 de l'enveloppe 13 de sa première extrémité à sa deuxième extrémité, en cheminant au moins sur une pale 11. De plus, le sillon 20 présente au moins un changement de direction 23 sur la pale 11 pour entrer et sortir d'un tronçon aérodynamique de la pale. Par exemple, au moins un sillon 20 chemine le long et/ou à proximité immédiate du bord d'attaque 16 de la pale 11.

Par exemple, un même sillon chemine sur plusieurs pales 11, voire sur toutes les pales 11 et sur le moyeu.

Par ailleurs, chaque équipement tournant comporte au moins un dégivreur 30.

Dès lors, chaque dégivreur 30 d'un équipement tournant 10 comprend une piste électriquement conductrice 31 agencée dans un sillon 20. Le dégivreur est ainsi intégré dans l'ensemble tournant, le dégivreur et l'ensemble tournant formant un tout indissociable. Cette piste électriquement conductrice 31 s'étend alors selon sa longueur d'une première borne 32 électrique jusqu'à une deuxième borne 33 électrique. La première borne 32 est agencée dans la première extrémité 21 d'un sillon 20, la deuxième borne 33 étant agencée dans la deuxième extrémité 22 de ce sillon.

Le cas échéant, une même piste électriquement conductrice 31 s'étend sur le moyeu 12 et sur au moins une pale 11, voire sur au moins deux pales 11. La première extrémité 21 et la deuxième extrémité 22 d'un sillon ainsi que ladite première borne 32 et ladite deuxième borne 33 de la piste électriquement conductrice disposée dans ce sillon sont présentes sur le moyeu 12.

Une piste électriquement conductrice 31 peut présenter une épaisseur et une largeur faibles rapportées à la tension électrique présente entre la première borne 32 et la deuxième borne 33 de cette piste électriquement conductrice 31. Par exemple, l'épaisseur et la largeur sont comprises entre 30 à 60 microns, ladite tension électrique étant comprise entre 12 Volts et 14 Volts.

Par ailleurs, le dégivreur 30 peut comprendre au moins une couche de protection 35 qui recouvre au moins une piste électriquement conductrice 31.

Les figures 2 à 4 illustrent un procédé de fabrication selon l'invention d'un tel ensemble tournant 10 équipé d'un dégivreur 30 intégré.

En référence à la figure 2, le procédé comporte une étape de fabrication de l'ensemble tournant 10.

La figure 2 illustre un ensemble tournant 10 comprenant une pale 11 par commodité pour illustrer l'invention. Toutefois, cet ensemble tournant 10 peut comprendre un moyeu, et éventuellement plusieurs pales formant une pièce monolithique.

Durant cette étape de fabrication, un ensemble tournant 10 muni d'une enveloppe 13 est fabriqué. En particulier, l'enveloppe 13 est réalisée au moins à partir d'un matériau muni d'un métal organique, par exemple un matériau composite chargé de cuivre.

Eventuellement, l'ensemble tournant 10 peut être réalisé en mettant en oeuvre un procédé de moulage, d'injection, d'impression 3D...

Eventuellement, l'étape de fabrication comporte une sous-étape de fabrication d'un ou plusieurs noyau(x) central(aux) 15, puis une sous-étape de recouvrement de chaque noyau central 15 par ladite enveloppe 13.

A l'issue de l'étape de fabrication, l'ensemble tournant 10 est ainsi obtenu. Cet ensemble tournant 10 comporte a minima une enveloppe 13 munie d'une face extérieure 14.

Dès lors et en référence à la figure 3, le procédé comporte une étape de réalisation avec un laser d'au moins un sillon 20 dans la face extérieure 14 selon un procédé de structuration directe au laser. Au moins un sillon s'étendant d'une première extrémité 21 vers une deuxième extrémité 22 est creusé par un laser dans l'enveloppe 13, le sillon 20 présentant au moins un changement de direction au niveau d'une pale 11.

Par suite et en référence à la figure 4, le procédé comporte une étape de réalisation d'une piste électriquement conductrice 31 d'un dégivreur 30.

Une piste électriquement conductrice 31 est ménagée dans chaque sillon 20 en plongeant l'ensemble tournant 10 dans un bain contenant un métal, selon un procédé de métallisation par électrolyse par exemple. Chaque piste électriquement conductrice 31 s'étend donc d'une première borne 32 jusqu'à une deuxième borne 33.

Eventuellement, au moins une piste électriquement conductrice 31 s'étend sur le moyeu 12 et sur au moins une pale 11, la première extrémité 21 et la deuxième extrémité 22 ainsi que la première borne 32 et la deuxième borne 33 étant présentes sur ledit moyeu 12.

Ensuite, le procédé comporte une étape de recouvrement d'une voire de chaque piste électriquement conductrice 31 avec une couche de protection 35. Par exemple, un vernis de polyuréthane est projeté sur chaque piste électriquement conductrice 31.

Le laser peut être dimensionné pour obtenir des pistes électriquement conductrices 31 présentant des dimensions particulières.

Par construction, chaque piste électriquement conductrice 31 s'étend sur une longueur entre la première borne 32 et la deuxième borne 33 de cette piste électriquement conductrice 31. De plus, la piste électriquement conductrice s'étend selon son épaisseur 36 d'une face inférieure 44 en contact avec un fond 41 dudit au moins un sillon 20 jusqu'à une face supérieure 38 recouverte de la couche de protection 35. En outre, la piste électriquement conductrice 31 s'étendant selon sa largeur 37 entre deux côtés 39, 40 respectivement en contact avec deux flancs 42, 43 du sillon accueillant la piste. Le laser peut alors être dimensionné afin que l'épaisseur 36 et la largeur 37 soient comprises chacune entre 30 microns inclus et 60 microns inclus.

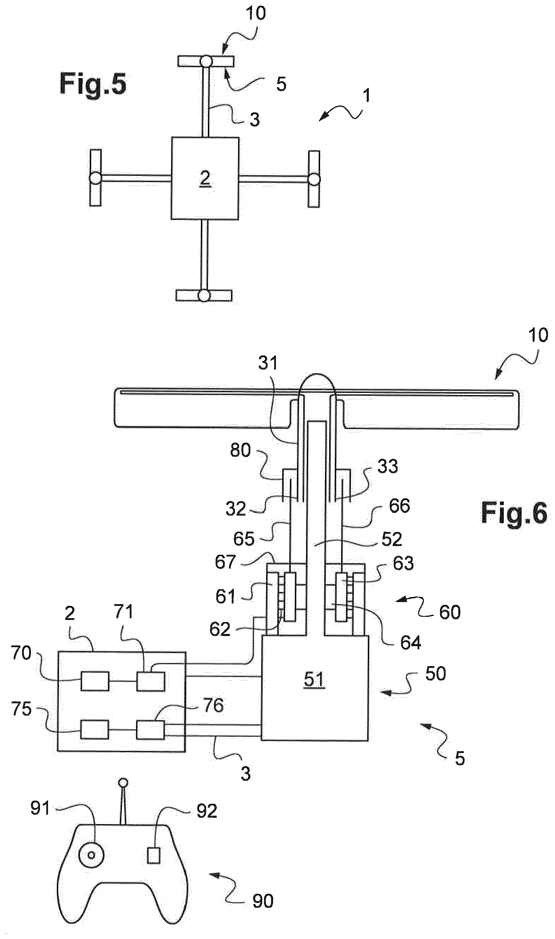

En référence à la figure 5, un équipement tournant selon l'invention peut être agencé sur un drone 1. Ce drone 1 peut comprendre un corps 2 portant au moins un rotor 5, par exemple par un bras 3. Ce rotor 5 comporte alors un équipement tournant selon l'invention. Eventuellement, chaque rotor 5 comporte un équipement tournant selon l'invention.

La figure 6 illustre un tel rotor 5 muni d'un équipement tournant selon l'invention. Eventuellement, cette architecture est reproduite sur tous les rotors 5.

Pour mettre en rotation l'ensemble tournant 10 d'un équipement tournant d'un rotor 5, le drone 1 comporte un moteur électrique 50. Ce moteur électrique 50 est relié à un organe de stockage d'énergie électrique 75, éventuellement via un interrupteur 76 ou équivalent. Le moteur électrique 50 ou le cas échéant l'interrupteur 76 peuvent être commandés à distance à l'aide d'une commande de pilotage 91 portée par une télécommande 90.

Le moteur électrique 50 est muni d'un bâti 51 qui est porté par un bras 3. Le moteur électrique 50 possède aussi un arbre de sortie qui est en sailli du bâti 51. Cet arbre de sortie matérialise un mât rotor 52 solidaire en rotation de l'ensemble tournant 10. Le mât rotor 52 est éventuellement plein. Par exemple, l'ensemble tournant comporte alors un moyeu 12 fixé à une zone d'extrémité libre du mât rotor par des moyens usuels, tels que des moyens de vissage, de collage, de rivetage, de soudure, d'agrafage...

Par ailleurs, le drone 1 comporte une source d'énergie électrique 70 pour faire circuler un courant électrique dans chaque piste électriquement conductrice 31 de l'ensemble tournant 10. Cette source d'énergie électrique 70 peut comporter une ou plusieurs batteries, au moins une pile.... Cette source d'énergie électrique 70 peut par exemple être localisée dans le corps 2. La source d'énergie électrique 70 peut délivrer un courant électrique sous une tension électrique par exemple comprise entre 12 Volts inclus et 14 Volts inclus. Par ailleurs, la source d'énergie électrique 70 et l'organe de stockage d'énergie électrique 75 cité précédemment peuvent constituer un seul et même moyen de stockage d'énergie électrique ou deux moyens de stockage d'énergie électrique différents.

Le drone est alors muni pour chaque rotor d'un collecteur électrique interposé électriquement entre la source d'énergie électrique et l'ensemble tournant de ce rotor, pour transférer un courant électrique du repère fixe du corps 2 vers un repère tournant du rotor 5 et de l'ensemble tournant 10.

Dès lors, le collecteur électrique 60 comprend une partie fixe 61 reliée électriquement à une partie mobile 63 de ce collecteur électrique 60.

La partie fixe 61 est éventuellement fixée au bâti 51 du moteur électrique, via le cas échéant un carter 67 de protection du collecteur électrique.

La partie mobile 63 est solidarisée au mât rotor 52, en étant traversée par ce mât rotor 52. Par exemple, la partie mobile 63 comporte un anneau entourant le mât rotor 52.

Eventuellement, la partie mobile 63 est fixée à un organe élastique 64 par des moyens usuels, tels que des moyens de vissage, de collage, de rivetage, de soudure, d'agrafage... Cet organe élastique 64 est de plus fixé au mât rotor 52. Par exemple, cet organe élastique comporte une bague et un cordon de colle fixant la bague au mât rotor 52.

Par ailleurs, la partie fixe 61 est électriquement en communication avec la partie mobile 63. Par exemple, le collecteur électrique est muni de balais 62 en contact avec des lignes électriques. Selon une variante, la partie fixe porte des balais, la partie mobile portant des lignes électriques en contact avec les balais. Selon une autre variante, la partie mobile porte des balais, la partie fixe portant des lignes électriques en contact avec les balais. La partie fixe peut entourer la partie mobile. La partie mobile peut entourer localement le mât rotor.

Tout type de collecteur électrique est toutefois envisageable.

Par ailleurs, la partie fixe 61 est reliée électriquement à la source d'énergie électrique 70 par une liaison électrique. Cette liaison électrique peut comprendre un ou plusieurs fils électriques ainsi qu'un interrupteur 71 ou équivalent.

Le cas échéant, l'interrupteur 71 d'un collecteur électrique peut être commandé à distance à l'aide d'une commande de dégivrage 92 portée par une télécommande 90. En présence de plusieurs ensembles tournants alimentés électriquement respectivement par plusieurs collecteurs électriques reliés à des interrupteurs, la commande de dégivrage peut commander tous les interrupteurs. De manière alternative, une source d'énergie électrique peut être reliée à un interrupteur 71, cet interrupteur 71 étant relié à tous les collecteurs électriques du drone.

Par ailleurs, la partie mobile 63 est reliée électriquement à la première borne 32 et à la deuxième borne 33 de chaque piste électriquement conductrice d'un ensemble tournant.

Dès lors, au moins deux fils 65, 66 s'étendent de la partie mobile 63 jusqu'à respectivement la première borne 32 et la deuxième borne 33 d'une piste électriquement conductrice.

Un premier fil 65 est ainsi disposé contre la première borne 32 et un deuxième fil 66 est accolé contre la deuxième borne 33. Un manchon 80 thermo-rétractable peut être agencé autour de cette connexion en entourant le premier fil 65 et le deuxième fil 66 ainsi que la première borne 32 et la deuxième borne 33.

Un tel système de fixation peut éventuellement permettre de démonter facilement l'ensemble tournant.

Naturellement, la présente invention est sujette à de nombreuses variations quant à sa mise en oeuvre. Bien que plusieurs modes de réalisation aient été décrits, on comprend bien qu'il n'est pas concevable d'identifier de manière exhaustive tous les modes possibles. Il est bien sûr envisageable de remplacer un moyen décrit par un moyen équivalent sans sortir du cadre de la présente invention.

## Revendications

1. Procédé de fabrication d'un équipement tournant pour drone (1), ledit équipement tournant comprenant un ensemble tournant (10) équipé d'un dégivreur (30), ledit ensemble tournant (10) comprenant au moins une pale (11),
**caractérisé en ce que** ledit procédé comporte la fabrication dudit d'un équipement tournant par un procédé de structuration directe au laser en réalisant les étapes de :
- fabrication dudit ensemble tournant (10), ledit ensemble tournant (10) comprenant une enveloppe (13), ladite enveloppe (13) comprenant un matériau composite muni d'un métal organique,
- réalisation avec un laser d'au moins un sillon (20) sur une face extérieure (14) de ladite enveloppe (13), ledit au moins un sillon (20) s'étendant d'une première extrémité (21) vers une deuxième extrémité (22), ledit au moins un sillon (20) étant au moins ménagé sur ladite pale (11), ledit au moins un sillon (20) présentant au moins un changement de direction sur ladite pale (11),
- réalisation d'une piste électriquement conductrice (31) du dégivreur (30) dans ledit au moins un sillon (20) en plongeant ledit ensemble tournant (10) dans un bain contenant un métal, ladite piste électriquement conductrice (31) s'étendant d'une première borne (32) jusqu'à une deuxième borne (33), la première borne (32) étant présente dans la première extrémité (21), la deuxième borne (33) étant présente dans la deuxième extrémité (22),
- recouvrement de ladite piste électriquement conductrice (31) avec une couche de protection (35).

2. Procédé selon la revendication 1,
**caractérisé en ce que** ladite fabrication dudit ensemble tournant (10) comporte une étape de confection d'un noyau central (15) et une étape de recouvrement dudit noyau central (15) avec ladite enveloppe (13).

3. Procédé selon l'une quelconque des revendications 1 à 2,
**caractérisé en ce que** ladite piste électriquement conductrice (31) s'étendant sur une longueur entre la première borne (32) et la deuxième borne (33), ladite piste électriquement conductrice (31) s'étendant selon une épaisseur (36) d'une face inférieure (44) en contact avec un fond (41) dudit au moins un sillon (20) jusqu'à une face supérieure (38), ladite piste électriquement conductrice (31) s'étendant selon une largeur (37) entre deux côtés (39, 40) respectivement en contact avec deux flancs (42, 43) dudit au moins un sillon (20), ladite épaisseur (36) et ladite largeur (37) sont comprises chacune entre 30 microns inclus et 60 microns inclus.

4. Procédé selon l'une quelconque des revendications 1 à 3,
**caractérisé en ce que** ledit ensemble tournant (10) comprenant au moins deux pales (11) et un moyeu (12), lesdites au moins deux pales (11) étant portées par ledit moyeu (12), lesdites au moins deux pales (11) et ledit moyeu (12) forment une pièce monolithique.

5. Procédé selon la revendication 4,
**caractérisé en ce que** ladite piste électriquement conductrice (31) s'étend sur ledit moyeu (12) et sur au moins une pale (11), ladite première extrémité (21) et ladite deuxième extrémité (22) ainsi que la première borne (32) et la deuxième borne (33) étant présentes sur ledit moyeu (12).

6. Equipement tournant muni d'un ensemble tournant pour drone, ledit ensemble tournant étant muni d'au moins une pale,
**caractérisé en ce que** ledit ensemble tournant (10) comporte une enveloppe (13), au moins un sillon (20) s'étendant sur une face extérieure (14) de ladite enveloppe (13) d'une première extrémité (21) vers une deuxième extrémité (22), ledit au moins un sillon (20) étant au moins ménagé sur ladite pale (11), ledit au moins un sillon (20) présentant au moins un changement de direction (23) sur ladite pale (11), ledit équipement tournant (10) comprenant au moins un dégivreur (30), ledit dégivreur (30) comprenant une piste électriquement conductrice (31) s'étendant dans ledit au moins un sillon (20), ladite piste électriquement conductrice (31) s'étendant d'une première borne (32) jusqu'à une deuxième borne (33), la première borne (32) étant présente dans la première extrémité (21), la deuxième borne (33) étant présente dans la deuxième extrémité (22), ledit dégivreur (30) comprenant une couche de protection (35) recouvrant ladite piste électriquement conductrice (31).

7. Equipement tournant selon la revendication 6,
**caractérisé en ce que** ledit ensemble tournant (10) comporte un noyau central (15) agencé dans ladite enveloppe (13).

8. Equipement tournant selon l'une quelconque des revendications 6 à 7,
**caractérisé en ce que** ladite piste électriquement conductrice (31) s'étendant sur une longueur entre la première borne (32) et la deuxième borne (33), ladite piste électriquement conductrice (31) s'étendant selon une épaisseur (36) d'une face inférieure (44) en contact avec un fond (41) dudit au moins un sillon (20) jusqu'à une face supérieure (38), ladite piste électriquement conductrice (31) s'étendant selon une largeur (37) entre deux côtés (39, 40) respectivement en contact avec deux flancs (42, 43) dudit au moins un sillon (20), ladite épaisseur (36) et ladite largeur (37) sont comprises chacune entre 30 microns inclus et 60 microns inclus.

9. Equipement tournant selon l'une quelconque des revendications 6 à 8,
**caractérisé en ce que** ledit ensemble tournant (10) comprenant au moins deux pales (11) et un moyeu (12), lesdites au moins deux pales (11) étant portées par ledit moyeu (12), lesdites au moins deux pales (11) et ledit moyeu (12) forment une pièce monolithique.

10. Equipement tournant selon la revendication 9,
**caractérisé en ce que** ladite piste électriquement conductrice (31) s'étend sur ledit moyeu (12) et sur au moins deux pales (11), ladite première extrémité (21) et ladite deuxième extrémité (22) ainsi que ladite première borne (32) et ladite deuxième borne (33) étant présentes sur ledit moyeu (12).

11. Equipement tournant selon l'une quelconque des revendications 6 à 10,
**caractérisé en ce que** ladite couche de protection (35) comporte un vernis polyuréthane.

12. Drone (1) muni d'un corps (2), ledit corps (2) portant au moins un rotor (5)
**caractérisé en ce que** ledit au moins un rotor (5) comporte un équipement tournant selon l'une quelconque des revendications 6 à 11.

13. Drone selon la revendication 12,
**caractérisé en ce que** ledit drone (1) comportant un moteur électrique (50) muni d'un bâti (51) et d'un mât rotor (52), ledit mât rotor (52) étant relié mécaniquement audit ensemble tournant (10), ledit drone (1) comporte un collecteur électrique (60), ledit collecteur électrique (60) ayant une partie fixe (61) reliée électriquement à une partie mobile (63), ladite partie fixe (61) étant reliée électriquement à une source d'énergie électrique (70), ladite partie mobile (63) étant reliée électriquement à ladite première borne (32) et à ladite deuxième borne (33), ladite partie mobile (63) étant solidarisée audit mât rotor (52) et étant agencée autour du mât rotor (52).

14. Drone selon la revendication 13,
**caractérisé en ce que** ladite partie mobile (63) est fixée à un organe élastique (64), ledit organe élastique (64) étant fixé au mât rotor (52).

15. Drone selon l'une quelconque des revendications 13 à 14,
**caractérisé en ce que** ladite partie fixe (61) est fixée audit bâti (51).

16. Drone selon l'une quelconque des revendications 13 à 15,
**caractérisé en ce qu'**au moins deux fils (65, 66) s'étendent de ladite partie mobile (63) jusqu'à respectivement ladite première borne (32) et ladite deuxième borne (33), un desdits au moins deux fils (65, 66) étant accolé à ladite première borne (32) et un desdits au moins deux fils étant accolé à ladite deuxième borne (33), un manchon (80) thermo-rétractable entourant lesdits fils (65, 66) ainsi que ladite première borne (32) et ladite deuxième borne (33).

17. Drone selon l'une quelconque des revendications 13 à 16,
**caractérisé en ce que** ladite source d'énergie électrique (70) délivre un courant électrique sous une tension électrique comprise entre 12 Volts inclus et 14 Volts inclus.

## Patentansprüche

1. Verfahren zur Herstellung einer drehbaren Ausrüstung für eine Drohne (1), wobei die drehbare Ausrüstung eine drehbare Anordnung (10) umfasst, die mit einem Enteiser (30) ausgestattet ist, und die drehbare Anordnung (10) mindestens ein Blatt (11) umfasst,
**dadurch gekennzeichnet, dass** das Verfahren die Herstellung der drehbaren Ausrüstung durch ein direktes Laserstrukturierungsverfahren unter Durchführung der folgenden Schritte umfasst:
- Herstellen der drehbaren Anordnung (10), wobei die drehbare Anordnung (10) eine Hülle (13) umfasst, wobei die Hülle (13) ein Verbundmaterial umfasst, das ein Organometall aufweist,
- Erzeugen von mindestens einer Nut (20) auf einer Außenfläche (14) der Hülle (13) mit einem Laser, wobei sich die mindestens eine Nut (20) von einem ersten Ende (21) zu einem zweiten Ende (22) erstreckt, wobei die mindestens eine Nut (20) mindestens auf dem Blatt (11) ausgebildet ist, wobei die mindestens eine Nut (20) mindestens eine Änderung der Richtung auf dem Blatt (11) aufweist,
- Erzeugen einer elektrischen Leiterbahn (31) des Enteisers (30) in der mindestens einen Nut (20) durch Eintauchen der drehbaren Anordnung (10) in ein ein Metall enthaltendes Bad, wobei sich die elektrische Leiterbahn (31) von einem ersten Anschluss (32) zu einem zweiten Anschluss (33) erstreckt, wobei der erste Anschluss (32) am ersten Ende (21) vorhanden ist und der zweite Anschluss (33) am zweiten Ende (22) vorhanden ist,
- Bedecken der elektrischen Leiterbahn (31) mit einer Schutzschicht (35).

2. Verfahren nach Anspruch 1,
**dadurch gekennzeichnet, dass** die Herstellung der drehbaren Anordnung (10) einen Schritt des Herstellens eines zentralen Kerns (15) und einen Schritt des Bedeckens des zentralen Kerns (15) mit der Hülle (13) umfasst.

3. Verfahren nach einem der Ansprüche 1 bis 2,
**dadurch gekennzeichnet, dass** sich die elektrische Leiterbahn (31) über eine Länge zwischen dem ersten Anschluss (32) und dem zweiten Anschluss (33) erstreckt, wobei sich die elektrische Leiterbahn (31) in Richtung einer Dicke (36) von einer Unterseite (44), die in Kontakt mit einem Boden (41) der mindestens einen Nut (20) ist, zu einer Oberseite (38) erstreckt, die elektrische Leiterbahn (31) sich in Richtung einer Breite (37) zwischen zwei Seiten (39, 40) erstreckt, die jeweils in Kontakt mit zwei Flanken (42, 43) der mindestens einen Nut (20) sind, wobei die Dicke (36) und die Breite (37) jeweils zwischen 30 Mikron einschließlich und 60 Mikron einschließlich liegen.

4. Verfahren nach einem der Ansprüche 1 bis 3,
**dadurch gekennzeichnet, dass** die drehbare Anordnung (10) mindestens zwei Blätter (11) und eine Nabe (12) umfasst, wobei die mindestens zwei Blätter (11) von der Nabe (12) getragen werden, und die mindestens zwei Blätter (11) und die Nabe (12) ein monolithisches Teil bilden.

5. Verfahren nach Anspruch 4,
**dadurch gekennzeichnet, dass** sich die elektrische Leiterbahn (31) über die Nabe (12) und mindestens ein Blatt (11) erstreckt, wobei das erste Ende (21) und das zweite Ende (22) sowie der erste Anschluss (32) und der zweite Anschluss (33) auf der Nabe (12) vorhanden sind.

6. Drehbare Ausrüstung für eine Drohne, mit einer drehbaren Anordnung, wobei die drehbare Anordnung mit mindestens einem Blatt versehen ist,
**dadurch gekennzeichnet, dass** die drehbare Anordnung (10) eine Hülle (13) und mindestens eine Nut (20) umfasst, die sich auf einer Außenfläche (14) der Hülle (13) von einem ersten Ende (21) zu einem zweiten Ende (22) erstreckt, dass die mindestens eine Nut (20) mindestens an der Schaufel (11) ausgebildet ist, dass die mindestens eine Nut (20) mindestens eine Richtungsänderung (23) an der Schaufel (11) aufweist, dass die drehbare Anordnung (10) mindestens einen Enteiser (30) umfasst, dass der Enteiser (30) eine elektrische Leiterbahn (31) umfasst, die sich in der mindestens einen Nut (20) erstreckt, dass sich die elektrische Leiterbahn (31) von einem ersten Anschluss (32) zu einem zweiten Anschluss (33) erstreckt, wobei der erste Anschluss (32) am ersten Ende (21) vorhanden ist, der zweite Anschluss (33) am zweiten Ende (22) vorhanden ist, dass der Enteiser (30) eine Schutzschicht (35) umfasst, die die elektrisch leitfähige Schiene (31) bedeckt.

7. Drehbare Ausrüstung nach Anspruch 6,
**dadurch gekennzeichnet, dass** die rotierende Anordnung (10) einen zentralen Kern (15) aufweist, der in der Hülle (13) angeordnet ist.

8. Drehbare Ausrüstung nach einem der Ansprüche 6 bis 7,
**dadurch gekennzeichnet, dass** sich die elektrische Leiterbahn (31) über eine Länge zwischen dem ersten Anschluss (32) und dem zweiten Anschluss (33) erstreckt, dass sich die elektrische Leiterbahn (31) in Richtung einer Dicke (36) von einer Unterseite (44), die in Kontakt mit einem "Boden (41) der mindestens einen Nut (20) ist, zu einer Oberseite (38) erstreckt, dass die elektrische Leiterbahn (31) sich in Richtung einer Breite (37) zwischen zwei Seiten (39, 40) erstreckt, die jeweils in Kontakt mit zwei Flanken (42, 43) der mindestens einen Nut (20) sind, wobei die Dicke (36) und die Breite (37) jeweils zwischen 30 Mikron einschließlich und 60 Mikron einschließlich liegen.

9. Drehbare Ausrüstung nach einem der Ansprüche 6 bis 8,
**dadurch gekennzeichnet, dass** die drehbare Anordnung (10) mindestens zwei Blätter (11) und eine Nabe (12) umfasst, wobei die mindestens zwei Blätter (11) von der Nabe (12) getragen werden, und die mindestens zwei Blätter (11) und die Nabe (12) ein monolithisches Teil bilden.

10. Drehbare Ausrüstung nach Anspruch 9,
**dadurch gekennzeichnet, dass** sich die elektrische Leiterbahn (31) über die Nabe (12) und mindestens zwei Blätter (11) erstreckt, wobei das erste Ende (21) und das zweite Ende (22) sowie der erste Anschluss (32) und der zweite Anschluss (33) auf der Nabe (12) vorhanden sind.

11. Drehbare Ausrüstung nach einem der Ansprüche 6 bis 10,
**dadurch gekennzeichnet, dass** die Schutzschicht (35) einen Polyurethanlack umfasst.

12. Drohne (1) mit einem Körper (2), wobei der Körper (2) mindestens einen Rotor (5) trägt, **dadurch gekennzeichnet, dass** der mindestens eine Rotor (5) eine drehbare Ausrüstung nach einem der Ansprüche 6 bis 11 umfasst.

13. Drohne nach Anspruch 12,
**dadurch gekennzeichnet, dass** die Drohne (1) einen Elektromotor (50) aufweist, der mit einem Gestell (51) und einem Rotormast (52) versehen ist, dass der Rotormast (52) mechanisch mit der drehbaren Anordnung (10) verbunden ist, dass die Drohne (1) einen elektrischen Stromabnehmer (60) aufweist, dass der elektrische Stromabnehmer (60) einen festen Teil (61) aufweist, der elektrisch mit einem beweglichen Teil (63) verbunden ist, dass der feste Teil (61) elektrisch mit einer Quelle elektrischer Energie (70) verbunden ist, dass der bewegliche Teil (63) elektrisch mit dem ersten Anschluss (32) und dem zweiten Anschluss (33) verbunden ist, und dass der bewegliche Teil (63) an dem Rotormast (52) befestigt und um den Rotormast (52) herum angeordnet ist.

14. Drohne nach Anspruch 13,
**dadurch gekennzeichnet, dass** der bewegliche Teil (63) an einem elastischen Element (64) befestigt ist, und dass das elastische Element (64) an dem Rotormast (52) befestigt ist.

15. Drohne nach einem der Ansprüche 13 bis 14,
**dadurch gekennzeichnet, dass** der feste Teil (61) an dem Gestell (51) befestigt ist.

16. Drohne nach einem der Ansprüche 13 bis 15,
**dadurch gekennzeichnet, dass** sich mindestens zwei Drähte (65, 66) von dem beweglichen Teil (63) zu jeweils dem ersten Anschluss (32) und dem zweiten Anschluss (33) erstrecken, dass einer der mindestens zwei Drähte (65, 66) an dem ersten Anschluss (32) und einer der mindestens zwei Drähte an dem zweiten Anschluss (33) befestigt ist, und dass eine wärmeschrumpfbare Hülse (80) die Drähte (65, 66) sowie den ersten Anschluss (32) und den zweiten Anschluss (33) umgibt.

17. Drohne nach einem der Ansprüche 13 bis 16,
**dadurch gekennzeichnet, dass** die elektrische Energiequelle (70) einen elektrischen Strom bei einer elektrischen Spannung zwischen 12 Volt einschließlich und 14 Volt einschließlich liefert.

## Claims

1. Method for producing a rotary system for a drone (1), the said rotary system comprising a rotary assembly (10) equipped with a de-icer (30), the said assembly (10) comprising at least one blade (11), **characterised in that** the said method comprises the production of the said rotary system using a laser-direct structuring method, by carrying out the following steps:
- producing the said rotary assembly (10), said rotary assembly (10) comprising a casing (13), the said casing (13) comprising a composite material provided with an organic metal,
- forming by means of a laser at least one groove (20) on an external surface (14) of the said casing, the said at least one groove extending from a first end (21) to a second end (22), the said at least one groove (20) being at least arranged on the said blade (11), the at least one groove (20) having at least one change of direction on the said blade (11),
- forming an electrically conducting track (31) of the de-icer (30) in the said at least one groove (20) by immersing the said rotary assembly (10) in a bath containing a metal, the said electrically conducting track (31) extending from a first terminal (32) up to a second terminal (33), the first terminal (32) being present in the first end (21), the second terminal (33) being present in the second end (22), and
- covering the said electrically conducting track (31) with a protective layer (35).

2. Method according to claim 1, **characterised in that** the said production of the said rotary assembly (10) comprises a step of making a central core (15) and a step of covering the said central core (15) with the said casing (13).

3. Method according to either one of claims 1 and 2, **characterised in that** the said electrically conducting track (31) extends over a length between the first terminal (32) and the second terminal (33), the said electrically conducting track (31) extends over a thickness (36) from a lower surface (44) in contact with a bottom (41) of the said at least one groove (20) up to an upper surface (38), the said electrically conducting track (31) extends over a width (37) between two sides (39, 40) respectively in contact with two edges (42, 43) of the said at least one groove (20), the said thickness (36) and the said width (37) each being between 30 microns inclusive and 60 microns inclusive.

4. Method according to any one of claims 1 to 3, **characterised in that** the said rotary assembly (10) comprises at least two blades (11) and a hub (12), the said at least two blades (11) being supported by the said hub (12), the said at least two blades (11) and the said hub (12) forming a monolithic part.

5. Method according to claim 4, **characterised in that** the said electrically conducting track (31) extends over the said hub (12) and over at least one blade (11), the said first end (21) and the said second end (22) as well as the first terminal (32) and the second terminal (33) being present on the said hub (12).

6. Rotary system provided with a rotary assembly for a drone, the said rotary assembly being provided with at least one blade, **characterised in that** the said rotary assembly (10) comprises a casing (13), at least one groove (20) extending over an external surface (14) of the said casing (13) from a first end (21) to a second end (22), the said at least one groove (20) being at least arranged on the said blade (11), the said at least one groove (20) having at least one change of direction (23) on the said blade (11), the said rotary assembly (10) comprising at least one de-icer (30), the said de-icer (30) comprising an electric conducting track (31) extending into the at least one groove (20), the said electrically conducting track (31) extending from a first terminal (32) up to a second terminal (33), the first terminal (32) being present in the first end (21), the second terminal (33) being present in the second end (22), the said de-icer (30) comprising a protective layer (35) covering the said electrically conducting track (31).

7. Rotary system according to claim 6, **characterised in that** the said rotary assembly (10) comprises a central core (15) arranged in the said casing (13).

8. Rotary system according to either one of claims 6 and 7, **characterised in that** the said electrically conducting track (31) extends over a length between the first terminal (32) and the second terminal (33), the said electrically conducting track (31) extends over a thickness (36) from a lower surface (44) in contact with a bottom (41) of the at least one groove (20) up to an upper surface (38), the said electrically conducting track (31) extends over a width (37) between two sides (39, 40) respectively in contact with two sides (42, 43) of the said at least one groove (20), the said thickness (36) and the said width (37) each being between 30 microns inclusive and 60 microns inclusive.

9. Rotary system according to any one of claims 6 to 8, **characterised in that** the said rotary assembly (10) comprises at least two blades (11) and a hub (12), the said at least two blades (11) being supported by the said hub (12), the said at least two blades (11) and the said hub (12) forming a monolithic part.

10. Rotary system according to claim 9, **characterised in that** the said electrically conducting track (31) extends over the said hub (12) and over at least two blades (11), the said first end (21) and the said second end (22) as well as the said first terminal (32) and the said second terminal (33) being present on the said hub (12).

11. Rotary system according to any one of claims 6 to 10, **characterised in that** the said protective layer (35) comprises a polyurethane varnish.

12. Drone (1) provided with a body (2), the said body (2) carrying at least one rotor (5), **characterised in that** the said at least one rotor (5) comprises a rotary system according to any one of claims 6 to 11.

13. Drone according to claim 12, **characterised in that** the said drone (1) comprises an electric motor (50) provided with a frame (51) and a rotor mast (52), the said rotor mast (52) being mechanically connected to the said rotary assembly (10), the said drone (1) comprises an electrical connector (60), the said electrical connector (60) having a fixed part (61) electrically connected to a moving part (63), the said fixed part (61) being electrically connected to a source of electrical energy (70), the said moving part (63) being electrically connected to the said first terminal (32) and to the said second terminal (33), the said moving part (63) being integral with the said rotor mast (52) and being arranged around the said rotor mast (52).

14. Drone according to claim 13, **characterised in that** the said moving part (63) is fixed to an elastic member (64), the said elastic member (64) being fixed to the rotor mast (52).

15. Drone according to either one of claims 13 or 14, **characterised in that** the said fixed part (61) is fixed to the said frame (51).

16. Drone according to any one of claims 13 to 15, **characterised in that** at least two wires (65, 66) extend from the said moving part (63) to respectively the said first terminal (32) and the said second terminal (33), one of the said at least two wires (65, 66) being connected to the first terminal (32) and one of the said at least two wires being connected to the said second terminal (33), a heat-shrinkable sleeve (80) surrounding the said wires (65, 66) as well as the said first terminal (32) and the said second terminal (33).

17. Drone according to any one of clams 13 to 16, **characterised in that** the said source of electrical energy (70) supplies an electric current under a voltage of between 12 volts inclusive and 14 volts inclusive.
